Europäisches Patentamt

European Patent Office

Office européen des brevets

(19)

(11) Publication number: **0 146 181**
**B1**

(12) **EUROPEAN PATENT SPECIFICATION**

(45) Date of publication of patent specification: **15.03.89**

(21) Application number: **84201803.8**

(22) Date of filing: **05.12.84**

(51) Int. Cl.⁴: **H 01 L 27/06,** H 01 L 21/20,
H 01 L 21/74, H 01 L 29/06

(54) Semiconductor device comprising a combined bipolar-field effect transistor.

(30) Priority: **16.12.83 US 562145**
**16.12.83 US 562144**

(43) Date of publication of application:
**26.06.85 Bulletin 85/26**

(45) Publication of the grant of the patent:
**15.03.89 Bulletin 89/11**

(84) Designated Contracting States:
**DE FR GB NL**

(56) References cited:
**DE-A-3 114 970**
**US-A-4 266 238**
**US-A-4 300 150**

**INTERNATIONAL ELECTRON DEVICES
MEETING, TECHNICAL DIGEST, 3rd-5th
December 1979, Washington, D.C., paper 10-1,
pages 238-241, IEEE, New York, US; J.A.
APPELS et al.: "High- voltage thin layer devices
(resurf devices)"**

(73) Proprietor: **N.V. Philips' Gloeilampenfabrieken
Groenewoudseweg 1
NL-5621 BA Eindhoven (NL)**

(72) Inventor: **Singer, Barry Mana**
**c/o INT. OCTROOIBUREAU B.V. Prof. Holstlaan 6**
**NL-5656 AA Eindhoven (NL)**
Inventor: **Stupp, Edward Henry**
**c/o INT. OCTROOIBUREAU B.V. Prof. Holstlaan 6**
**NL-5656 AA Eindhoven (NL)**
Inventor: **Yayaraman, Rajsekhar**
**c/o INT. OCTROOIBUREAU B.V. Prof. Holstlaan 6**
**NL-5656 AA Eindhoven (NL)**

(74) Representative: **Houbiers, Ernest Emile Marie
Gerlach et al
INTERNATIONAAL OCTROOIBUREAU B.V. Prof.
Holstlaan 6
NL-5656 AA Eindhoven (NL)**

(56) References cited:
**IEEE INTERNATIONAL SOLID-STATE CIRCUITS
CONFERENCE, vol. 24, February 1981, pages
28,29, IEEE, New York, US; B. DESCAMPS et
al.: "WAM2.3: Integrated high-voltage video
amplifier for color TV"**

Courier Press, Leamington Spa, England.

EP  0 146 181  B1

(58) References cited:
**INTERNATIONAL ELECTRON DEVICES
MEETING TECHNICAL DIGEST, 5th-7th
December 1983, Washington, DC, paper 16.4,
pages 420-423, IEEE, New York, US; A.R.
ALVAREZ et al.: "Lateral DMOS transistor
optimized for high voltage BIMOS
applications"**

**PATENTS ABSTRACTS OF JAPAN, vol. 5, no.
181 (E-83)853r, 20th November 1981; & JP - A -
56 110 264**

## Description

### Background of the invention

The invention relates to a combined bipolar-field effect transistor RESURF device, comprising

a semiconductor substrate of a first conductivity type and having a major surface and a substrate electrode connected to the side of said substrate opposite said major surface,

an epitaxial surface layer of a second conductivity type opposite to that of said first conductivity type, the doping concentration and thickness of said epitaxial surface layer being selected in accordance with the REduced SURface Field (RESURF) technique,

a surface-adjoining base region of said first conductivity type in said epitaxial surface layer, a base electrode connected to said base region,

a surface-adjoining source/emitter region of said second conductivity type in said base region, the source/emitter region serving both as the source and the emitter of said combined device,

a source/emitter electrode connected to said source/emitter region,

a surface-adjoining drain/collector region of said second conductivity type in said epitaxial surface layer and spaced apart from said base region, the drain/collector region serving as both the drain and the collector of said combined device,

a drain/collector electrode connected to said drain/collector region,

a surface-adjoining channel region at least partly in that portion of said base region which is adjacent said drain/collector region,

an insulating layer on said surface layer and covering at least that part of said channel region which is in said base region and

a gate electrode on said insulating layer and over at least that part of said channel region which is in said base region.

Such a device is known from U.S. Patent No. 4,300,150.

The general concept of combining bipolar and field effect transistors in a single device is well-known in the art. For example, combined bipolar-junction field effect transistor devices are shown in U.S. Patent No. 4,095,252 and *IBM Technical Disclosure Bulletin*, Vol. 19, No. 11, April 1977, p. 4191—4192. Additionally, a combined vertical bipolar-DMOS device is shown in U.S. Patent No. 4,344,081. Generally speaking, when such devices are used for high-power switching applications, a bipolar transistor and a field effect transistor are combined in order to achieve a single integrated device which features both the faster switching response of the field effect transistor and the lower on-resistance of the bipolar transistor.

In order to achieve a higher level of performance in such devices, an ongoing effort has been made to improve the breakdown and switching characteristics of the devices. For example, it has been found that the breakdown characteristics of high-voltage semiconductor devices generally can be improved by using the REduced SURface Field (or RESURF) technique, as dsscribed in "High Voltage Thin Layer Devices (RESURF Devices)", "International Electronic Devices Meeting Technical Digest", December 1979, pages 238—240, by Appels et al, and U.S. Patent No. 4,292,642, incorporated herein by reference. Essentially, the improved breakdown characteristics of RESURF devices are achieved by employing thinner but more highly doped epitaxial surface layers to reduce surface fields.

The RESURF technique was applied to lateral double-diffused MOS transistors, as described in U.S. Patent 4,300,150 and also in "Lateral DMOS Power Transistor Design", "IEEE Electron Device Letters", Vol. EDL-1, pages 51—53, April 1980, by Colak et al, and the result was a substantial improvement in device characteristics. In high-voltage DMOS devices, there is normally a trade-off between breakdown voltage and on-resistance, with the goal being to increase the breakdown voltage level while maintaining a relatively low on-resistance. Using the RESURF technique, and for reference assuming a constant breakdown voltage, an improvement (e.g. decrease) in on-resistance by a factor of about 3 may be obtained in a device occupying the same area as a conventional (thick epitaxial layer) DMOS device. Nevertheless, a further improvement in the on-resistance and switching characteristics of such devices would be extremely desirable, particularly for high-voltage power switching devices where such characteristics are of considerable importance. Additionally, for combined bipolar-field effect transistor devices using the RESURF principle, it would be desirable to improve the manufacturing yield and minimize the area occupied by the device for a given set of switching, high-voltage, and on-resistance characteristics.

### Summary of the invention

It is therefore an object of the present invention to provide a combined bipolar-field effect transistor RESURF device having improved on-resistance and switching characteristics, while requiring a reduced amount of base drive current for a desired level of on-resistance and having a reduced amount of unwanted internal power dissipation.

It is a further object of the invention to provide a combined bipolar-field effect transistor RESURF device in which the manufacturing yield is improved and the area occupied by the device is minimized for a given set of switching, high-voltage, and on-resistance characteristics, and in which both isolation and switching speed are improved.

In accordance with the invention a combined bipolar-field effect transistor RESURF device as described in the preamble is characterized in that the device comprises a lightly-doped epitaxial buried layer of said first conductivity type on said major surface of the substrate and having a doping level at least an order of magnitude less than that of said substrate.

In such a device, the improved on-resistance and switching characteristics mentioned above are achieved by using minority carriers for conductivity modulation, by exploiting the vertical base widening phenomenon, and by using a double-epi construction to confine minority carriers. These improvements are made possible by the incorporation of the lightly-doped epitaxial buried layer, which is located between the substrate and the epitaxial surface layer of the device.

According to an important preferred embodiment the device according to the invention comprises a highly-doped buried region of said second conductivity type located beneath said base region and sandwiched between said epitaxial buried layer of the first conductivity type and said epitaxial surface layer of the second conductivity type. Such a highly-doped buried region reduces the base drive current and the internal power dissipation of the device.

Devices in accordance with the invention may also include a buried annular region of the first conductivity type around and in contact with the highly-doped buried region, as well as a surface-adjoining annular region of the first conductivity type adjacent the base region.

The various embodiments described above may additionally include a highly-doped buried layer, of the same conductivity type as that of the substrate, located in the substrate at its intersection with the lightly-doped epitaxial buried layer. This highly-doped buried layer serves to increase conductivity modulation in the lightly-doped epitaxial buried layer and also to enhance confinement of carriers to the lightly-doped epitaxial buried layer.

Such devices not only require reduced base drive for a given level of on-resistance and provide reduced internal power dissipation, but also provide improved isolation with respect to adjacent devices on the same substrate and improved switching speed.

Brief description of the drawing

Figure 1 is a cross-sectional view of a combined bipolar-field effect transistor RESURF device in accordance with a first embodiment of the invention; and

Figure 2 is a cross-sectional view of a combined bipolar-field effect transistor RESURF device in accordance with a second embodiment of the invention.

Figure 3 is a cross-sectional view of a combined bipolar-field effect transistor RESURF device in accordance with a third embodiment of the invention;

Figure 4 is a cross-sectional view of a combined bipolar-field effect transistor RESURF device in accordance with a fourth embodiment of the invention; and

Figure 5 is a cross-sectional view of a combined bipolar-field effect transistor RESURF device in accordance with a fifth embodiment of the invention.

Description of the preferred embodiments

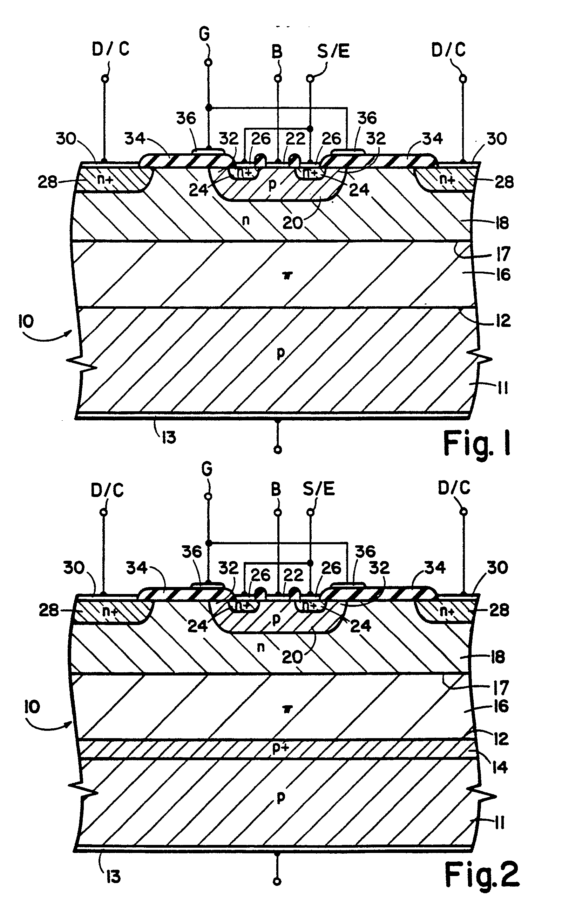

Figure 1 of the drawing shows a combined bipolar-field effect transistor RESURF device which is suitable for high voltage switching applications. It should be noted that the drawing is not to scale, and in particular that the vertical dimensions are exaggerated for improved clarity. Additionally, like parts are designated with like reference numerals in the figures, and semiconductor regions of the same conductivity type are shown hatched in the same direction.

In Figure 1, a combined bipolar-field effect transistor RESURF device 10 has a semiconductor substrate 11 with a major surface 12 on its upper side and a substrate electrode 13 on its lower side. In this example the substrate 11 is of p conductivity type and has a doping level of at least about $3 \times 10^{15}$ atoms/cm$^3$. A lightly doped epitaxial buried layer 16 is located on surface 12 of the substrate and has a doping level of at least an order of magnitude (a factor of 10 times) less than that of the substrate. The lightly-doped epitaxial buried layer here is of π (i.e. p−) conductivity type with a doping level of about $3 \times 10^{14}$ atoms/cm$^3$ and a thickness of about 30 microns. An epitaxial surface layer 18 of n conductivity type is located on the upper surface 17 of π layer 16, and has a doping concentration N and thickness d selected in accordance with the REduced SURface Field (RESURF) technique, meaning that the total doping concentration per unit area of the layer (N×d) is of the order of abo/t $10^{12}$ atoms per square cm. In this example, the epitaxial surface layer 18 has a doping level of about $10^{15}$ atoms/cm$^3$ and a thickness of about 10 microns.

The active regions of the combined bipolar-field effect transistor RESURF device are formed at the upper surface of epitaxial surface layer 18. A surface-adjoining base region 20 of p conductivity type and a doping level of about $10^{17}$ atoms/cm$^3$ is provided with a base electrode 22 and a surface-adjoining source/emitter region 24 of n+ conductivity type semiconductor material, with region 24 serving as both the source and the emitter of the combined bipolar-field effect transistor device. Region 24 is provided with a source/emitter electrode 26 connected to the upper surface of the region.

A drain/collector region 28 of n+ conductivity type is provided adjacent the surface of the epitaxial surface layer 18 and is spaced apart from the base region 20, with a drain/collector electrode 30 connected to the upper surface of the drain/collector region. Thus a lateral npn bipolar transistor is integrally formed with a lateral MOS field effect transistor.

A surface-adjoining channel region 32 is located between source/emitter region 24 and drain/collector region 28, and is at least partly located in that portion of the base region which is adjacent to the drain/collector region. This latter-mentioned portion of the channel region 24 is covered by an insulating layer 34 of a material such as silicon dioxide or other suitable insulating material, with a gate electrode 36 being provided on the insulating layer 34 and over at least that part of the channel region which is in the base region 20. Since the various active regions of the device described above are formed in a conventional manner, they will not be discussed in further detail.

The improved operational features of the present invention are achieved by using minority carriers for conductivity modulation and by exploiting the vertical base widening phenomenon typical of lateral RESURF devices to obtain lower specific on-resistances and increased yield for a given current and voltage rating. Additionally, the configuration of this device does not compromise the attributes of low input capacitance and ease of integration which are characteristic of devices of this general type.

In the device of Figure 1, the π layer 16 serves as the substrate for purposes of blocking voltage, and, during the "off" state, this layer is fully depleted. When the device of Figure 1 is turned "on", a vertical pnp transistor is formed from regions of p layers 11 and 16, n layer 18 and p region 20. In the "on" state, layers 16 and 18 will be conductivity modulated by minority carriers.

To turn the device of Figure 1 "on", base and gate drive signals are applied to electrodes 22 and 36, respectively. This first activates the field effect transistor, and then, following a short delay, the lateral npn bipolar transistor switches "on". Due to the existence of a low-resistance channel region along the surface of the device, the lateral transistor switches immediately into saturation, with both the base-emitter and base-collector junctions forward biased. The forward biasing of the base-collector junction in turn triggers the vertical pnp transistor discussed above, and hole current flows to the substrate.

When the doping level of layer 16 is appropriately selected with respect to that of the underlying substrate, a potential will develop across these layers, even at a relatively low base current. If the potential drop becomes comparable to the built-in potential of the collector-base junction of the vertical pnp transistor, this transistor will also saturate. At this point, electrons will be injected from the epitaxial surface layer 18 into the highly resistive layer 16, effectively widening the base of the vertical pnp transistor. Due to the relatively small electric fields in layer 16, the base widening phenomenon spreads rapidly to the pπ junction 12, where holes are also injected into layer 16. Due to the large number of carriers injected into the layer 16 from both the epitaxial surface layer 18 (from above) and the substrate 11 (from below), the intervening layer 16 region becomes heavily conductivity modulated. The voltage required to maintain this situation is now dropped across the substrate resistance alone. As the base current further increases, the base widening phenomenon spreads laterally through the π layer. Additionally, lateral base widening effects in the lateral npn bipolar transistor become significant, so that eventually the entire extended epitaxial layer (layers 16 and 18) becomes further

modulated due to the combined effects of both vertical and lateral base widening.

As a result, the effective cross-sectional area of the device is increased, since layer 16 in effect acts to extend the epitaxial surface layer. Furthermore, the entire extended epitaxial layer (16, 18) is conductivity modulated. As a result, the on-resistance of the device is dramatically reduced, since these two effects are nearly multiplicative in their influence on the conductive-state resistance of the device. While the device is in this conductive state, the carriers in the modulated layer 16 and the epitaxial surface layer 18 are maintained by a recombination current from the base region 20. Since the lifetime of the high-resistivity region is large, the recombination current will be small in comparison to the current delivered to the external load, thus enhancing device efficiency.

In addition to increasing the effective area of the device and reducing the overall on-resistance, as discussed above, the present invention also permits more design flexibility in the location of emitting and collecting regions, since these regions no longer need be alternated as in conventional lateral transistor designs. Since layer 16 is converted to n conductivity type through the base widening phenomenon, this layer may act as a low resistance buried collector region, thus permitting emitting regions to be arranged for optimum efficiency and maximum emitting surface area and packing density. As a final advantage, the present configuration also reduces the number of regions that experience high electric fields, which increases overall device yield.

To return the device of Figure 1 to the "off" state, base drive to electrode 22 is first removed. Holes from the modulated layer 16 will then be collected through the base 20 and substrate 11. Electrons from layer 16 will flow to the drain/collector region 28. Since the current paths for both holes and electrons are relatively low resistance paths, a further advantage of the invention is that the turn-off time will be quite rapid. As the modulated layer 16 is converted back to its high resistivity "off" state, current flow becomes limited to the epitaxial surface layer 18, and is handled by the field effect transistor portion of the device alone. After conversion of layer 16 is complete, the field effect transistor is switched "off" to return the device to its quiescent state.

A second embodiment of a combined bipolar-field effect transistor RESURF device is shown in Figure 2. This device differs from the device shown in Figure 1 in that a highly-doped p+ conductivity type buried layer 14 is provided in the substrate 11 at major surface 12. In other respects, the device of Figure 2 corresponds to the device previously described with reference to Figure 1, with like reference numerals being used to designate like regions in the two figures. Accordingly, the description of Figure 2 will be limited to the highly-doped buried layer and its effect upon device performance.

In Figure 2, a highly-doped p+ buried layer 14 is provided at major surface 12 of the substrate 11.

This highly-doped p+ buried layer has a doping level of about $10^{18}$ atoms/cm³ and a thickness of about 5 microns. The highly doped buried layer 14 serves to increase the injection efficiency of the substrate 11 relative to that of the epitaxial surface layer 18, thereby increasing conductivity modulation of layer 16 and creating a barrier to electron flow into the substrate, thus confining the base widening phenomenon to layer 16 where it most effective. As a result, improved device speed and better lateral isolation may be obtained.

Preliminary test results on several experiment device in accordance with the invention indicate that a very substantial improvement in device performance can be achieved. As compared to prior art combined bipolar-field effect transistor devices, for example, "on" resistance may be decreased from 3 to 10 times, with all other performance characteristics remaining substantially constant. When this substantial improvement in performance is combined with the other advantages mentioned above, it will be seen that the present invention constitutes a substantial commercial advance in the art.

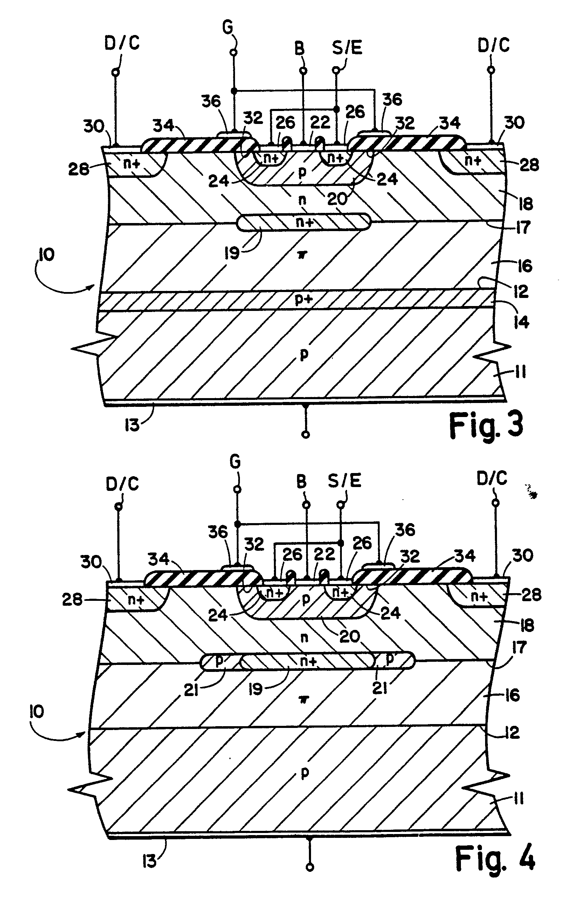

It should be understood that while buried layer 14 is shown only in Figure 2 and 3, the devices shown in Figures 1, 4 and 5 may all be fabricated either with or without this buried layer.

Figure 3 of the drawing shows a third embodiment of the device according to the invention. This device differs from the device shown in Figure 2 in that a highly-doped buried region 19 is located beneath the base region 20 and sandwiched between the epitaxial buried layer 16 and the epitaxial surface layer 18 at the surface 17. In other respects the device of Figure 3 corresponds to the device previously described with reference to Figure 2, the same reference numerals being used for corresponding regions and parts.

In this example, buried region 19 is of n+ conductivity type and has a doping level in the range of about $10^{18}$—$10^{20}$ atoms/cm³ and a thickness in the range of about 1—2 microns.

Since highly-doped n+ buried region 19 acts as a barrier to holes, hole concentration gradients are increased in the region of the base, and the base widening effects are enhanced.

Because of the addition of buried region 19, the beta of the vertical transistor is reduced, so that hole current to the substrate is minimized. In this manner, the amount of base drive current for a desired on-resistance is reduced, and unwanted internal power dissipation is lowered. At the same time, desired hole current in the lateral direction is enhanced, thus improving lateral conductivity and lowering on-resistance. More particularly, the addition of buried layer 19 can reduce the required base drive current for a given level of on-resistance by a factor of two, so that a considerably smaller base drive power source may be used. Additionally, both operating speed and device isolation are improved by reducing vertical conductivity and enhancing lateral conductivity.

Preliminary test results on several experimental devices in accordance with the invention indicate that incorporation of the highly-doped n+ buried region 19 reduced the base current drive requirement by a factor of 2.

In Figure 4, a device as described above is additionally provided with a buried annular region 21 around and in contact with highly-doped buried region 19. In this example, the buried annular region is of p conductivity type and has a doping level in the range of about $3 \times 10^{15}$—$1 \times 10^{16}$ atoms/cm³ and a thickness in the range of about 1—2 microns.

This annular region serves several purposes. During the "on" state, this region acts as an equipotential region and allows uniform conductivity modulation of the epitaxial surface layer 18. When the annular region 21 becomes forward biased, holes from the base region 20 are collected in the annular region and are reinjected back into the epitaxial surface layer. This improves the injection efficiency of the device, further lowers the amount of base drive current needed to obtain a given level of on-resistance by a factor of 2—3, and improves isolation with respect to other devices sharing the same substrate. Furthermore, during the "off" state, the annular region tends to offset the field crowding tendencies of the buried region 19, thus improving breakdown characteristics.

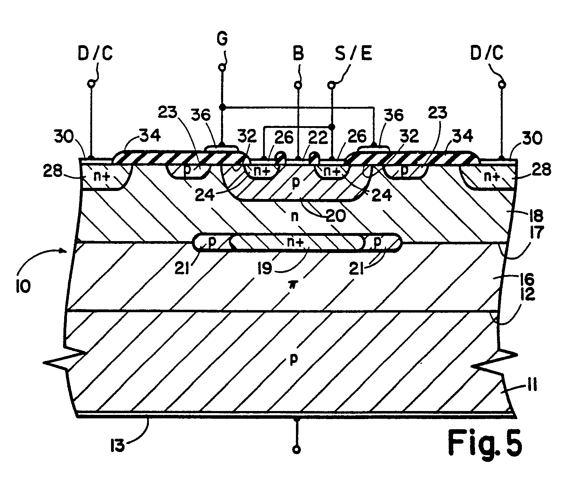

In Figure 5, a device having buried regions 19 and 21 as described above is further provided with a surface-adjoining annular region 23 adjacent the base region 20. Region 23 in this example is of p conductivity type, with a doping level of about $10^{16}$ atoms/cm³ and a thickness of about 1 micron.

As in the case of region 21, surface-adjoining annular region 23 serves several purposes. As an additional field-shaping layer, it improves the high voltage capabilities of the device. Additionally, in the "on" state it provides uniform conductivity modulation of the epitaxial surface layer and serves as an additional source of injected holes closer to the drain region. As a result, device efficiency and speed are further improved.

## Claims

1. A combined bipolar-field effect transistor RESURF device, comprising

a semiconductor substrate of a first conductivity type and having a major surface and a substrate electrode connected to the side of said substrate opposite said major surface,

an epitaxial surface layer of a second conductivity type opposite to that of said first conductivity type, the doping concentration and thickness of said epitaxial surface layer being selected in accordance with the REduced SURface Field (RESURF) technique,

a surface-adjoining base region of said first conductivity type in said epitaxial surface layer, a base electrode connected to said base region,

a surface-adjoining source/emitter region of said second conductivity type in said base region, the source/emitter region serving both as the source and the emitter of said combined device,

a source/emitter electrode connected to said source/emitter region,

a surface-adjoining drain/collector region of said second conductivity type in said epitaxial surface layer and spaced apart from said base region, the drain/collector region serving as both the drain and the collector of said combined device,

a drain/collector electrode connected to said drain/collector region,

a surface-adjoining channel region at least partly in that portion of said base region which is adjacent said drain/collector region,

an insulating layer on said surface layer and covering at least that part of said channel region which is in said base region and

a gate electrode on said insulating layer and over at least that part of said channel region which is in said base region, characterized in that the device comprises a lightly-doped epitaxial buried layer of said first conductivity type on said major surface of the substrate and having a doping level at least an order of magnitude less than that of said substrate.

2. A combined bipolar-field effect transistor RESURF device as claimed in Claim 1, characterized in that said lightly-doped epitaxial buried layer is of p conductivity type and has a doping level of about $3 \times 10^{14}$ atoms/cm$^3$ and a thickness of about 30 microns.

3. A combined bipolar-field effect transistor RESURF device as claimed in Claim 1, characterized in that a highly-doped buried layer of said first conductivity type is present in said substrate at said major surface, the doping level of said highly-doped buried layer being greater than that of said substrate.

4. A combined bipolar-field effect transistor RESURF device as claimed in anyone of the preceding claims, characterized in that the device comprises a highly-doped buried region of said second conductivity type located beneath said base region and sandwiched between said epitaxial buried layer of the first conductivity type and said epitaxial surface layer of the second conductivity type.

5. A combined bipolar-field effect transistor RESURF device as claimed in Claim 4, characterized in that said highly-doped buried region is of n+ conductivity type and has a doping level in the range of about $10^{18}$—$10^{20}$ atoms/cm$^3$ and a thickness in the range of about 1—2 microns.

6. A combined bipolar-field effect transistor RESURF device as claimed in Claims 3, 4 and 5, characterized in that said highly-doped buried layer is of p$^+$ conductivity type and has a doping level of about $10^{18}$ atoms/cm$^3$ and a thickness of about 5 microns.

7. A combined bipolar-field effect transistor RESURF device as claimed in anyone of Claims 4, 5 or 6, characterized in that the device comprises a buried annular region of said first conductivity type around and in contact with the highly-doped buried region of said second conductivity type.

8. A combined bipolar-field effect transistor RESURF device as claimed in Claim 7, characterized in that said buried annular region is of p conductivity type and has a doping level in the range of about $3 \times 10^{15}$—$1 \times 10^{16}$ atoms/cm$^3$ and a thickness in the range of about 1—2 microns.

9. A combined bipolar field effect transistor RESURF device as in Claim 7, further comprising a surface-adjoining annular region of said first conductivity type adjacent said base region.

10. A combined bipolar-field effect transistor RESURF device as in Claim 9, wherein said surface-adjoining annular region is of p conductivity type and has a doping level of about $10^{16}$ atoms/cm$^3$ and a thickness of about 1 micron.

**Patentansprüche**

1. Eine kombinierte Bipolar-Feldeffekt RESURF-Anordnung mit einem Halbleitersubstrat eines ersten Leitungstyps und mit einer Hauptfläche und einer Substrateleketrode, die mit derjenigen Seite des genannten Substrats verbunden ist, die gegenüber der genannten Hauptfläche liegt,

einer epitaxialen Oberflächenschicht eines zweiten, dem ersten Leitungstyp entgegengesetzten Leitungstyp, wobei die Dotierungskonzentration und die Dicke dieser epitaxialen Oberflächenschicht entsprechend der RESURF (Verringerte Oberflächenfeld)-Technik gewählt ist,

einem an die Oberfläche grenzenden Basisgebiet vom ersten Leitungstyp in der genannten epitaxialen Oberflächenschicht, wobei eine Basiselektrode mit diesem Basisgebiet verbunden ist,

einem an die Oberfläche grenzenden Source/Emittergebiet vom zweiten Leitungstyp in dem genannten Basisgebiet, wobei das Source-/Emittergebiet als Source sowie als Emitter der genannten kombinierten Anordnung wirksam ist,

einer mit dem genannten Source-/Emittergebiet verbunden Source-/Emitterelektrode,

einem an die Oberfläche grenzenden Drain-/Kollektorgebiet vom zweiten Leitungstyp in der epitaxialen Oberflächenschicht und in einem Abstand von dem Basisgebiet, wobei das Drain-/Kollektorgebiet als Drain sowie als Kollektor der genannten kombinierten Anordnung wirsam ist,

einer mit dem genannten Drain-/Kollektorgebiet verbundenen Drain-/Kollektorelektrode,

einem an die Oberfläche grenzenden Kanalgebiet, das wenigstens teilweise in demjenigen Teil des Basisgebietes liegt, das neben dem Drain-/Kollektorgebiet liegt,

einer Isolierschicht auf der genannten Oberflächenschicht, wobei diese Isolierschicht wenigstens einen in dem Basisgebiet liegenden Teil des Kanalgebietes bedeckt, und

einer Gate-Elektrode auf der genannten Isolierschicht und über wenigstens denjenigen Teil des Kanalgebietes, der in dem Basisgebiet liegt, dadurch gekennzeichnet, dass die Anordnung eine schwachdotierte vergrabene Epitaxialschicht vom ersten Leitungstyp auf der Hauptoberfläche des Substrats aufweist mit einem Dotierungsspegel, der um wenigstens eine Ordnungsgrösse niedriger ist als der des Substrats.

2. Kombinierte Bipolar-Feldeffekt RESURF-Anordnung nach Anspruch 1, dadurch gekennzeichnet, dass die schwachdotierte vergrabene Epitaxialschicht vom p-Leitungstyp ist und einen Dotierungspegel von etwa $3 \times 10^{14}$ Atomen/cm$^3$ und eine Dicke von etwa 30 µm hat.

3. Kombinierte Bipolar-Feldeffekt RESURF-Anordnung nach Anspruch 1, dadurch gekennzeichnet, dass in dem Substrat an der Hauptoberfläche eine hochdotierte vergrabene Schicht vom ersten Leitungstyp vorhanden ist, wobei der Dotierungspegel der hochdotierten vergrabenen Schicht höher ist als der des Substrats.

4. Kombinierte Bipolar-Feldeffekt RESURF-Anordnung nach einem der vorstehenden Ansprüche, dadurch gekennzeichnet, dass die Anordnung ein hochdotiertes vergrabenes Gebiet vom zweiten Leitungstyp aufweist, das unterhalb des Basisgebietes und zwischen der vergrabenen Epitaxialschicht vom ersten Leitungstyp und der epitaxialen Oberflächenschicht vom zweiten Leitungstyp liegt.

5. Kombiniert Bipolar-Feldeffekt RESURF-Anordnung nach Anspruch 4, dadurch gekennzeichnet, dass das hochdotierte vergrabene Gebiet n$^+$-leitend ist und einen Dotierungspegel im Bereich von etwa $10^{18}$—$10^{20}$ Atomen/cm$^3$ und eine Dicke im Bereich von etwa 1—2 µm aufweist.

6. Kombinierte Bipolar-Feldeffekt RESURF-Anordnung nach den Ansprüchen 3, 4 und 5, dadurch gekennzeichnet, dass die hochdotierte vergrabene Schicht p$^+$-leitend ist und einen Dotierungspegel von etwa $0^{18}$ Atomen/cm$^3$ und eine Dicke von etwa 5 µm aufweist.

7. Kombinierte Bipolar-Feldeffekt RESURF-Anordnung nach einem der Ansprüche 4, 5 oder 6, dadurch gekennzeichnet, dass die Anordnung ein vergrabenes ringförmiges Gebiet vom ersten Leitungstyp um und in Kontakt mit dem hochdotierten vergrabenen Gebit vom zweiten Leitungstyp aufweist.

8. Kombinert Bipolar-Feldeffekt RESURF-Anordnung nach Anspruch 7, dadurch gekennzeichnet, dass das genannte vergrabene ringförmige Gebiet p-leitend ist und einen Dotierungspegel im Bereich von etwa $3 \times 10^{15}$—$1 \times 10^{16}$ Atomen/cm$^3$ und eine Dicke im Bereich von etwa 1—2 µm aufweist.

9. Kombinierte Bipolar-Feldeffekt RESURF-Anordnung nach Anspruch 7, dadurch gekennzeichnet, dass sie zusätzlich ein an die Oberfläche grenzendes ringförmiges Gebiet vom ersten Leitungstyp neben dem genannten Basisgebeit enthält.

10. Kombinierte Bipolar-Feldeff RESURF-Anordnung nach Anspruch 9, wobei das an die Oberfläche grenzende ringförmige Gebiet p-leitend ist und einen Dotierungspegel von etwa $10^{16}$ Atomen/cm$^3$ und eine Dicke von etwa 1 µm aufweist.

**Revendications**

1. Transistor RESURF combiné bipolaire et à effet de champ comportant

un substrat semiconductor d'un premier type de conductivité ayant une surface principale et une électrode de substrat reliée à la face dudit substrat située à l'opposé de ladite surface principale,

une couche épitaxiale superficielle d'un second type de conductivité, opposé audit premier type de conductivité, la concentration de dopage et l'épaisseur de ladite couche superficielle épitaxiale étant choisies conformes à la technique dite REduced SURface Field (RESURF) en langue anglaise,

une région de base dudit premier type de conductivité contiguë à la surface et située dans ladite couche épitaxiale superficielle, une électrode de base étant reliée à ladite région de base,

une région de source/d'émetteur dudit second type de conductivité contiguë à la surface et située dans ladite région de base, la région de source/d'émetteur servant à la fois de source et d'émetteur dudit dispositif composé,

une électrode de source/d'émetteur reliée à ladite région de source/d'émetteur,

une région de drain/de collecteur dudit second type de conductivité contiguë à la surface et située dans ladite couche épitaxiale superficielle et séparée de ladite région de base, la région de drain/de collecteur servant à la fois de drain et de collecteur dudit dispositif composé,

une électrode de drain/de collecteur reliée à ladite région de drain/de collecteur,

une région de canal contiguë à la surface et située au moins partiellement dans la partie de ladite région de base, contiguë à ladite région de drain/de collecteur,

une couche isolante située sur ladite couche superficielle et recouvrant au moins la partie de ladite région de canal, située dans ladite région de base et

une électrode de grille située sur ladite couche isolante et au-dessus d'au moins la partie de ladite région de canal, située dans ladite région de base, caractérisé en ce qu'il comporte une couche épitaxiale enterrée faiblement dopée dudit premier type de conductivité, située sur ladite surface principale du substrat et ayant un niveau de dopage au moins inférieur d'un ordre de grandeur à celui dudit substrat.

2. Transistor RESURF combiné bipolaire et à effet de champ selon la revendication 1, caractérisé en ce que ladite couche épitaxiale enterrée faiblement dopée est de type de conductivité p et a un niveau de dopage approximativement de $3 \times 10^{14}$ atomes/cm$^3$ et une épaisseur approximativement de 30 microns.

3. Transistor RESURF combiné bipolaire et à effet de champ selon la revendication 1, caractérisé en ce qu'une couche enterrée fortement dopée dudit premier type de conductivité est située dans ledit substrat, sur ladite surface principale, le niveau de dopage de ladite couche enterrée fortement dopée étant supérieur à celui dudit substrat.

4. Transistor RESURF combiné bipolaire et à effet de champ selon l'une quelconque des revendications précédentes, caractérisé en ce qu'il comporte une région enterrée fortement dopée dudit second type de conductivité, située au-dessous de ladite région de base et enfermée entre ladite couche épitaxiale enterrée du premier type de conductivité et ladite couche épitaxiale superficielle du second type de conductivité.

5. Transistor RESURF combiné bipolaire et à effet de champ selon la revendication 4, caractérisé en ce que ladite région enterrée fortement dopée est de type de conductivité n+ et a un niveau de dopage compris entre $10^{18}$ et $10^{20}$ atomes/cm$^3$ environ et une épaisseur comprise entre 1 et 2 microns environ.

6. Transistor RESURF combiné bipolaire et à effet de champ selon les revendications 3, 4 et 5, caractérisé en ce que ladite couche enterrée fortement dopée est de type de conductivité p+ et a un niveau de dopage de l'ordre de $10^{18}$ atomes/cm$^3$ et une épaisseur de 5 microns environ.

7. Transistor RESURF combiné bipolaire et à effet de champ selon l'une quelconque des revendications 4, 5 et 6, caractérisé en ce qu'il comporte une région annulaire enterrée dudit premier type de conductivité entourant la région enterrée fortement dopée dudit second type de conductivité tout en étant en contact avec celle-ci.

8. Transistor RESURF combiné bipolaire et à effet de champ selon la revendication 7, caractérisé en ce que ladite région annulaire enterrée est de type de conductivité p et a un niveau de dopage compris entre $3 \times 10^{15}$ et $1 \times 10^{16}$ atomes/cm$^3$ environ et une épaisseur comprise entre 1 et 2 microns environ.

9. Transistor RESURF combiné bipolaire et à effet de champ selon la revendication 7, comportant en outre une région annulaire dudit premier type de conductivité contiguë à la surface et située à côté de ladite région de base.

10. Transistor RESURF combiné bipolaire et à effet de champ selon la revendication 9, dans lequel ladite région annulaire contiguë à la surface est de type de conductivité p et a un niveau de dopage de l'ordre de $10^{16}$ atomes/cm$^3$ et une épaisseur de 1 micron environ.

EP 0 146 181 B1

Fig. 1

Fig.2

Fig. 3

Fig. 4

2

Fig. 5